**Europäisches Patentamt**

**European Patent Office**

**Office européen des brevets**

(11) Veröffentlichungsnummer: **0 502 452 A1**

# EUROPÄISCHE PATENTANMELDUNG

(21) Anmeldenummer: **92103524.2**

(22) Anmeldetag: **01.03.92**

(51) Int. Cl.5: **H03K 17/96**

(30) Priorität: **05.03.91 CH 656/91**

(43) Veröffentlichungstag der Anmeldung:
**09.09.92 Patentblatt 92/37**

(84) Benannte Vertragsstaaten:
**AT BE CH DE DK ES FR GB GR IT LI LU MC NL PT SE**

(71) Anmelder: **DYNALAB AG**
**Gewerbestrasse 10**
**CH-6330 Cham(CH)**

(72) Erfinder: **Schenk, Marc**
**Luzernstrasse 11**
**CH-5634 Merenschwand(CH)**
Erfinder: **Dogwiler, Jörg**
**Höhenweg 1**
**CH-5734 Reinach(CH)**

(74) Vertreter: **Blum, Rudolf Emil Ernst et al**
**c/o E. Blum & Co Patentanwälte Vorderberg 11**
**CH-8044 Zürich(CH)**

(54) **Selbstleuchtende, piezoelektrische Tastatur.**

(57) Um eine Tastatur zu beleuchten, deren Tasten als piezoelektrische Festkörperelemente (4) ausgebildet sind, die sich zwischen einer Grund- und einer Deckfolie (6, 8) befinden, wird vor der Deckfolie (8) eine Lichtemitterfolie (14) angeordnet. Diese leuchtet bei entsprechender Speisung vollflächig. Vor der Lichtemitterfolie (14) befindet sich eine Maske (18) mit lichtdurchlässigen und lichtundurchlässigen Zonen, die als Tastenbeschriftung gestaltet sind. Diese Maske kann innenseitig auf eine transparente Frontplatte (17) aufgedruckt sein.

Die Beleuchtung lässt sich auf einfache Weise in der Tastatur integrieren und lässt deren visuelle Gestaltung weitgehend frei.

Fig.1

Die Erfindung betrifft eine piezoelektrische Tastatur mit mehreren, in Tastenfeldern angeordneten Tasten, wobei zwischen einer gemeinsamen Grund- und Deckfolie bei Jedem Tastenfeld ein piezoelektrisches Element auf einer im wesentlichen starren Stützscheibe angeordnet und mittels Leiterbahnen an Grund- und Deckfolie kontaktiert ist, wobei die Kristalle so abgestützt sind, dass sie bei praktisch wegloser Tastenbetätigung Spannungssignale erzeugen, die als Tastensignale auswertbar sind und wobei eine stabile Frontplatte zur Abdeckung der Tastatur vorgesehen ist.

Tastaturen dieser Art sind z.B. aus der EP-A-210 386 bekannt. Sie weisen unter anderem den Vorteil auf, dass sie sehr flach sind, keiner Ermüdung bei häufiger Betätigung unterliegen und hinter einer massiven Frontplatte angeordnet werden können.

Ein Nachteil besteht bisher indessen darin, dass für solche Tastaturen im Tastenbereich keine Beleuchtung vorgesehen war, da die Anordnung von Lichtquellen hinter den Tasten wegen den lichtundurchlässigen piezoelektrischen Elementen bzw. Leiterbahnen auf Schwierigkeiten stiess. Es ist deshalb versucht worden, Lichtquellen in den Bereichen zwischen den Tasten anzuordnen. Dies wiederum führt dazu, dass die Beschriftungen auf den Tasten durch die beleuchtete Umgebung überstrahlt und damit im Gegenlicht schwer lesbar werden.

Es stellt sich deshalb die Aufgabe, eine Tastatur der erwähnten Art so mit einer Beleuchtung zu versehen, dass diese Nachteile nicht auftreten, ohne dass dadurch jedoch die Funktionstüchtigkeit der Tastatur selbst und ihre oben genannten Vorteile beeinträchtigt werden.

Diese Aufgabe wird durch die in den Patentansprüchen definierten Merkmalen gelöst.

Durch die Anordnung von an sich bekannten Lichtemitterfolien vor der Deckfolie der Tastatur lässt sich der gesamte Tastaturbereich vollflächig beleuchten. Wird eine geeignete Maske so vor der Lichtemitterfolie angeordnet, dass sie der dahinter angeordneten Tastatur entspricht, so entsteht für den Benutzer der Eindruck beleuchteter Einzeltasten. Vorzugsweise wird die Maske hinter einer transparenten stabilen Frontplatte angeordnet, welche als Schutz und zugleich als Bedienungsfläche der Tastatur dient. Der auf die Frontplatte ausgeübte Fingerdruck wird dann durch die Frontplatte und die Lichtemitterfolie hindurch auf das piezoelektrische Festkörperelement übertragen, welches auf diese Beanspruchung hin ein Tastensignal erzeugt. Vorzugsweise sind im Folienaufbau Mittel vorgesehen, dass diese Beanspruchung auf Biegung erfolgt. Insbesondere ist auf der Deckfolie über jedem piezoelektrischen Element eine punktförmige Zwischenlage angeordnet, über welche die Beanspruchung im Zentrum des Elements konzentriert wird, was zusammen mit dessen Abstützung im Randbereich zu einem leichten Ansprechen jeder Taste bei gleichzeitiger Verhinderung des Uebersprechens zwischen den Tasten beiträgt.

Nachfolgend werden nun anhand der Zeichnungen Ausführungsbeispiele der Erfindung näher erläutert. Es zeigen:

Fig. 1 den Folienaufbau bei einer Taste in Schnittdarstellung;

Fig. 2 eine Ansteuerschaltung für die Lichtemitterfolie;

Fig. 3 zwei mögliche Maskenarten für die Tastenfelder, und

Fig. 4 eine Schaltung zur Steuerung der Helligkeitsfunktion durch die Tasten selbst.

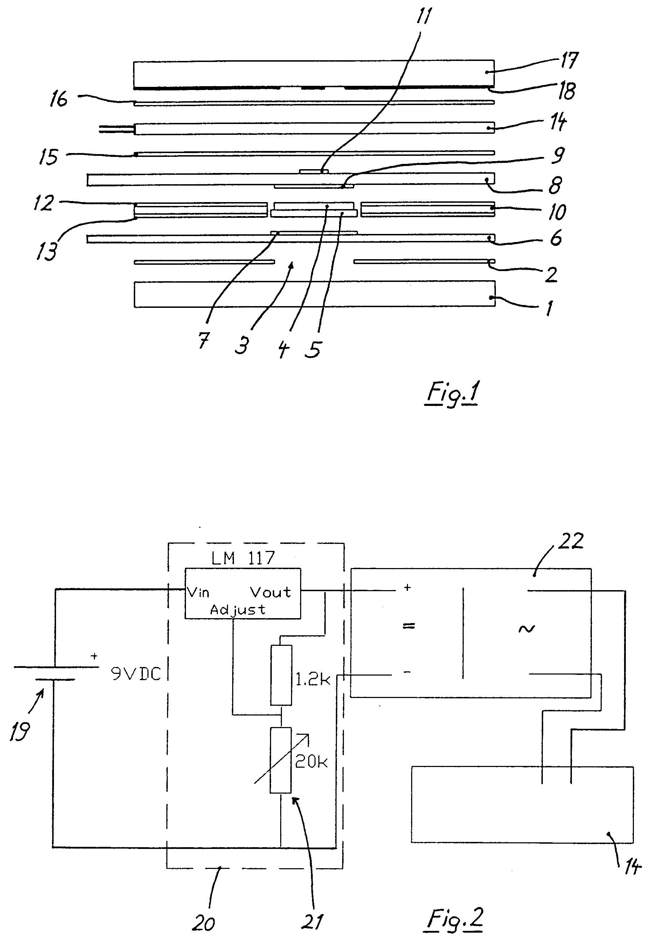

In der Figur 1 ist zunächst der Folienaufbau der Tastatur in einem Tastenfeld dargestellt.Unter dem Begriff Tastenfeld wird der funktionelle Bereich einer Taste verstanden, der von aussen nicht notwendigerweise als solcher erkennbar sein muss. Dabei versteht es sich, dass eine Mehrzahl entsprechender Tasten in derselben Folienanordnung enthalten sind, und dass die Folien- bzw. Plattendicken stark übertrieben dargestellt sind (ca. 8 : 1). Ferner sind die einzelnen Folien bzw. Platten im fertigen Zustand vollflächig miteinander verbunden und bilden einen integralen Körper mit Schichtstruktur ohne bewegliche Teile. Die Tastenbetätigung erfolgt, wie bereits ausgeführt, durch Uebertragung des Fingerdrucks auf die piezoelektrischen Elemente ohne merklichen Tastenweg.

Der Folienaufbau gemäss der Fig. 1 besteht, von hinten nach vorn, aus folgenden Einzelschichten:

Eine Tragplatte 1 bildet die mechanische Abstützung. Darauf ist ein Basiskleber 2 in Form einer Klebefolie angeordnet, welche im Bereich der piezoelektrischen Festkörperelemente Oeffnungen 3 besitzt, so dass jedes Element 4 bzw. seine Tragscheibe 5 lediglich im Randbereich abgestützt ist. Als solche Elemente 4 können scheibenförmige Piezokristalle verwendet werden. Eine Grundfolie 6 trägt Leiterbahnen 7 zur Kontaktierung der unteren Fläche des Piezokristalls über die Tragscheibe 5, die als Metallplatte ausgebildet ist. Zwischen dieser Grundfolie 6 und einer Deckfolie 8, welche ebenfalls Leiterbahnen 9 trägt, ist eine Abstandhalterfolie 10 aus inkompressiblem Material angeordnet. Diese besitzt Aufnahmeöffnungen für die Piezokristalle 4 auf ihren Tragscheiben 5. Die Abstandhalterfolie 10 ist mittels den Klebschichten 13, 12 mit der Grund- und Deckfolie verbunden (mit Ausnahme der Aufnahmeöffnungen für die Kristalle). Auf der Deckfolie 8 ist jeweils eine punktförmige Zwischenlage 11 im Zentrum jedes Kristalls 4 angeordnet. Dieser kann als Aufdruck aus Isolierlack mit einer Dicke von ca. 20 μ ausgebildet sein. Er dient zusammen mit der bereits erwähnten Oeffnung 3 im Basiskleber 2 dazu, den Betätigungsdruck optimal auf den Kristall 4 zu übertragen, so dass dieser auf Biegung beansprucht wird. Dies ist besonders von Bedeutung bei der Anordnung einer zusätzlichen Lichtemitterfolie 14, welche mittels Overlaykleberschichten 15, 16 mit der Deckfolie 8 bzw. einer Frontplatte 17 verbunden ist, um die Gefahr des Uebersprechens zwischen benachbarten Tastenfeldern auszuschliessen.

Lichtemitterfolien sind an sich bekannt. Sie werden als "Elektroluminescent Foils" u.a. von der Firma Loctite Luminescent Systems Inc., USA, hergestellt. Solche Lichtemitterfolien sind in sich selbst wieder mehrschichtig aufgebaut. Sie beginnen beim Anlegen einer definierten Wechselspannung durch den Effekt der Elektrolumineszenz vollflächig zu leuchten.

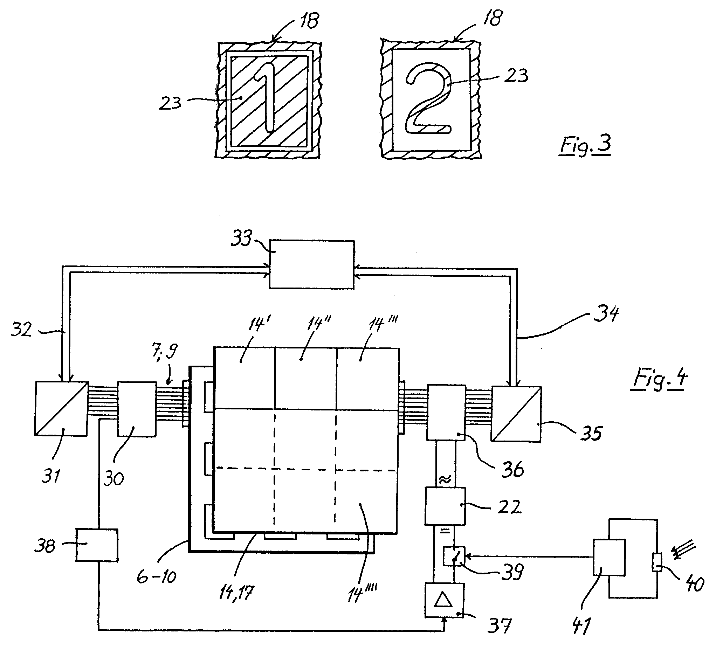

Die vor der Lichtemitterfolie angeordnete Frontplatte 17 besteht aus einem transparenten, zähen Kunststoff z.B. PMMA (Plexiglas) einer Dicke von z.B. 1 mm und dient als Schutz für die Tastatur. Sie kann vorderseitig absolut flach sein und trägt an ihrer Rückseite eine Maske 18, welche als lichtundurchlässiger Aufdruck 23 ausgebildet sein kann und die einzelnen Tastenfelder markiert (vergl. z.B. Fig. 3). Die Maske 18 kann auch als zusätzliche Folie ausgebildet sein bzw. als Veränderung der Struktur der Frontplatte 17 zur Beeinflussung ihrer Lichtdurchlässigkeit.

Wie in Fig. 3 schematisch gezeigt, kommen grundsätzlich zwei Maskenausgestaltungen für die Tastenbeleuchtung in Frage, nämlich die Beleuchtung der Tastenbeschriftung bzw. der Tastenumrandung einerseits (links in Fig. 3) oder die Beleuchtung des Tastenhintergrunds mit dagegen kontrastierender, lichtundurchlässiger Beschriftung andererseits (rechts in Fig. 4). Die erfindungsgemässe Anordnung hat den Vorteil, wahlweise eine dieser Beleuchtungsarten oder beide kombiniert zuzulassen.

Die Beleuchtungsstärke in den lichtdurchlässigen Zonen der Maske ist durch die Grösse und/oder die Frequenz der an die Lichtemitterfolie angelegten Spannung gegeben und nimmt mit zunehmender Lebensdauer der Folie ab. Zur Kompensation kann die Betriebsspannung mit der Zeit erhöht werden. In Fig. 2 ist eine mögliche Ansteuerschaltung für die Lichtemitterfolie 14 schematisch dargestellt. Eine Gleichspannungsquelle 19, z.B. eine Batterie, speist einen Spannungsregler (Dimmer) 20, dessen Ausgangsspannung mittels einem Potentiometer 21 einstellbar ist. In einem Umrichter 22 wird die Gleichspannung in eine Wechselspannung bestimmter Frequenz (z.B. 400 Hz) und einstellbarem Spannungswert gewandelt. Mit dieser Wechselspannung wird die Lichtemitterfolie 14 gespeist, welche in einer der Speisespannung entsprechenden Leuchtstärke vollflächig Licht abstrahlt. Mit der gezeigten Schaltung kann die Leuchtstärke von Hand mittels einem Dimmerknopf nachgestellt werden. Die Einstellung der Leuchtstärke kann, wie anhand der Fig. 4 veranschaulicht wird, auch über die Tastatur selbst erfolgen. In Fig. 4 ist schematisch eine Schaltungsanordnung gezeigt, in welche sowohl die Tastenbetätigung als auch die Tastenbeleuchtung einbezogen ist. Fig. 4 ist so zu verstehen, dass auch einzelne der darin vorgesehenen Funktionen weggelassen werden können. In dieser Figur sind zur besseren Uebersicht die tastentragenden Folien 6 bis 10 von der darüber liegenden Beleuchtungsfolie 14 und Deckplatte 17 getrennt dargestellt.

Die Detektion der Tastensignale als solche soll hier nicht im einzelnen erläutert werden. Es kann diesbezüglich z.B. auf die in der DE-A-40 35 261.7 beschriebene Schaltung verwiesen werden. In Fig. 4 geschieht diese Detektion in der Tastaturinterfaceschaltung 30, welche von jeder Taste die Spannungssignale über die Leiterbahnen 7, 9 erhält und in normierte Digitalsignale verwandelt. In einem Codierer 31 wird jeder Tastenbetätigung ein Codewort zugeordnet, das über einen Bus 32 an eine Logikschaltung 33 gelangt. Diese steuert dann die entsprechenden Funktionen, welche mit der Tastenbedienung ausgelöst werden sollen.

Eine dieser Funktionen kann nun die Tastenbeleuchtung selbst sein, wozu die Logikschaltung 33 mit den Schaltungsteilen verbunden ist, welche die Tastenbeleuchtung betreffen.

In Fig. 4 ist ein Fall dargestellt, bei welchem die Lichtemitterfolie 14 in mehrere, unabhängig voneinander betreibbare Bereiche unterteilt ist. Diese Bereiche können einzelnen Tasten bzw. Tastengruppen zugeordnet sein, so dass im betreffenden Bereich die Taste bzw. Tasten z.B. blickend beleuchtet werden können. Damit lässt sich ein Dialog mit dem Benutzer aufbauen, indem jeweils diejenige Taste bzw. Tastengruppe durch Blinken und/oder durch helleres bzw. weniger helles Leuchten den Benutzer auf sich aufmerksam macht, die in einer Prioritätenfolge als nächste zu bedienen ist. Die Logikschaltung 33 gibt entsprechend dieser Prioritätenfolge codierte Signale über einen Bus 34 aus, die in einem Decodierer 35 in Steuersignale für die Speisung der einzelnen Bereiche der Lichtemitterfolie verwandelt werden. Diese Steuersignale betätigen Blink- bzw. Steuermodule, die in einer Beleuchtungs-Interfaceschaltung 36 den einzelnen Speiseleitungen zugeordnet sind.

Die Speisung selbst erfolgt, wie beschrieben, über einen Umrichter 22. Zur Einstellung der Leuchtstärke der Lichtemitterfolie kann dessen Eingangsspannung durch Betätigung einer dazu vorgesehenen Taste der Tastatur beeinflusst werden. Hierzu ist die Tastaturinterfaceschaltung 30 mit einem Digital-Analog-Wandler 38 verbunden, dessen Ausgangssignal als Steuersignal für einen Analogverstärker 37 dient, der mit dem Umrichter 22 verbunden ist.

Schliesslich ist in Fig. 4 als weitere Funktion eine Steuerung der Beleuchtung in Abhängigkeit vom Aussenlicht dargestellt. Das ist insbesondere bei batteriebetriebenen Tastaturen zur Stromersparnis erwünscht, jedoch auch zur Verlängerung der Lebensdauer der Lichtemitterfolie von Vorteil. Ueber einen Schalter 39 in der Speiseleitung kann bei ausreichendem Aussenlicht die Beleuchtung selbsttätig ausgeschaltet werden. Das Aussenlicht kann über einen Photowiderstand 40 gemessen werden. In einer Entscheidungsstufe 41 (Spannungs-Komparator) wird beim Ueberschreiten eines bestimmten Schwellenwerts der Schalter 39 geöffnet und damit die Beleuchtung ausgeschaltet. Es ist von Vorteil, den Photowiderstand ebenfalls in die Tastatur zu integrieren, d.h. hinter der Frontplatte 17 anzuordnen. Auf diese Weise kann eine unnötige Beleuchtung am Tage, z.B. bei Tastaturen an öffentlich aufgestellten Automaten, verhindert werden.

Die beschriebene, beleuchtete Tastatur ist wegen dem Fehlen beweglicher Teile und dem Schutz durch die Frontplatte insbesondere für den Einsatz unter rauhen Bedingungen, wie Wettereinflüsse, Einwirkungen von Vandalen etc., geeignet. Ebenso kann sie als Tastatur an Geräten, die im Dunkeln zu bedienen sind, wie z.B. militärischen Apparaten oder Dunkelkammer-Ausrüstungen, eingesetzt werden und sie ist als Tastatur im Innern von Fahr- oder Flugzeugen geeignet.

Die beschriebene Tastatur besitzt den Vorteil, dass die Tastenbeleuchtung mit nur geringem konstruktivem Zusatzaufwand erzielt werden kann, wobei die Funktionstüchtigkeit der Tastatur selbst nicht beeinträchtigt wird. Die Beleuchtung kann in die Folienstruktur integriert werden und ist damit vor äusseren Einflüssen geschützt. Da die Beleuchtung grundsätzlich vollflächig über die ganze Tastatur zur Verfügung steht, lässt sich mit der Gestaltung entsprechender Masken auf einfache Weise eine fast beliebige Anordnung der Beleuchtung erzielen, ohne dass hierfür konstruktive Aenderungen nötig sind.

Die Tastatur kann in Verbindung mit einer elektronischen Schaltung für die Daten- und/oder Befehlseingabe vorgesehen sein. Die Tastenbeleuchtung gestattet dabei auf einfache Art eine Lichtquittierung, indem sich bei korrekter Eingabe die Betriebsart der Beleuchtung einzelner Tasten, z.B. von Dauerbetrieb auf Blinken, ändert und dem Benutzer so eine visuelle Eingabehilfe bietet.

**Patentansprüche**

1. Piezoelektrische Tastatur mit mehreren, in Tastenfeldern angeordneten Tasten, wobei zwischen einer gemeinsamen Grund- und Deckfolie (6, 8) bei jedem Tastenfeld ein piezoelektrisches Festkörperelement (4) auf einer im wesentlichen starren Stützscheibe (5) angeordnet und mittels Leiterbahnen (7, 9) an Grund- und Deckfolie kontaktiert ist, wobei die Elemente (4) so abgestützt sind, dass sie bei praktisch wegloser Tastenbetätigung Spannungssignale erzeugen, die als Tastensignale auswertbar sind und wobei eine stabile Frontplatte (17) zur Abdekkung der Tastatur vorgesehen ist, dadurch gekennzeichnet, dass über der Deckfolie (8) mindestens im Bereich der Tastenfelder eine Lichtemitterfolie (14) angeordnet ist, dass die Frontplatte (17) mindestens teilweise transparent ist, und dass über der Lichtemitterfolie (14) eine Maske (18) vorgesehen ist, die lichtdurchlässige und lichtundurchlässige Zonen aufweist, wobei sich innerhalb der Tastenfelder jeweils mindestens eine lichtdurchlässige Zone befindet.

2. Tastatur nach Anspruch 1, dadurch gekennzeichnet, dass die piezoelektrischen Elemente (4) auf ihrer Stützscheibe (5) in Oeffnungen einer im wesentlichen inkompressiblen Abstandhalterfolie (10) entsprechender Dicke angeordnet sind, welche zwischen der Grund- und der Deckfolie (6, 8) angeordnet und mit diesen verbunden ist.

3. Tastatur nach einem der vorangehenden Ansprüche, dadurch gekennzeichnet, dass die Frontplatte (17) eine Lage aus transparentem Kunststoff oder Glas aufweist.

4. Tastatur nach Anspruch 3, dadurch gekennzeichnet, dass die Maske (18) als lichtundurchlässige Schicht an der Innenseite der Frontplatte (17) angeordnet oder aufgedruckt ist.

5. Tastatur nach einem der vorangehenden Ansprüche, dadurch gekennzeichnet, dass zur Abstützung der piezoelektrischen Elemente eine starre Tragplatte (1) vorgesehen ist, die unter der Grundfolie (6) angeordnet ist.

6. Tastatur nach Anspruch 5, wobei die Grundfolie (6) mittels einer Klebschicht (2) mit der starren Tragplatte (1) verbunden ist, dadurch gekennzeichnet, dass die Abstützung der piezoelektrischen Elemente (4) bzw. ihrer Stützscheibe (5) im Randbereich durch eine entsprechende Ausnehmung (3) in der Klebschicht (2) unter jedem Tastenfeld gebildet ist derart, dass das Element bzw. seine Stützscheibe an ihrem Rand durch die Klebschicht (2) unterstützt sind.

7. Tastatur nach einem der vorangehenden Ansprüche, dadurch gekennzeichnet, dass die genannten Folien (6, 8, 10, 14) sowie die Frontplatte (17) und die Tragplatte (1) miteinander im wesentlichen über ihre gesamte Fläche mittels Klebschichten (2, 12, 13, 15, 16) verbunden sind.

8. Tastatur nach einem der vorangehenden Ansprüche, dadurch gekennzeichnet, dass im Zentrum jedes Tastenfeldes zwischen der Deckfolie (8) und der Lichtemitterfolie (14) je eine punktförmige Zwischenlage (11) mit einer geringeren Ausdehnung als das piezoelektrische Element (4) vorgesehen ist zur zentralen Druckbeaufschlagung desselben.

9. Tastatur nach einem der vorangehenden Ansprüche, dadurch gekennzeichnet, dass die Lichtemitterfolie (14) an eine Treiberschaltung (22) zur Speisung der Lichtemitterfolie mit einer Wechselspannung definierter Grösse und Frequenz angeschlossen ist, und dass die Tasten mit einem Tastaturinterface (30) zur Auswertung der Tastenbetätigungen verbunden sind, wobei das Tastaturinterface (30) mit der Treiberschaltung (22) so verbunden ist, dass durch Tastenbetätigung die Speisung der Lichtemitterfolie zur Helligkeitssteuerung beeinflussbar ist.

10. Tastatur nach einem der vorangehenden Ansprüche, dadurch gekennzeichnet, dass die Lichtemitterfolie (14) an eine Treiberschaltung (22) zur Speisung der Lichtemitterfolie mit einer Wechselspannung definierter Grösse und Frequenz angeschlossen ist, und dass ferner ein Helligkeitssensor (40) vorgesehen ist, mittels welchem die Treiberschaltung (22) in Abhängigkeit des Umgebungslichts selbsttätig ein- bzw. ausschaltbar ist.

11. Tastatur nach einem der vorangehenden Ansprüche, dadurch gekennzeichnet, dass die Lichtemitterfolie (14) in mehrere, unabhängig voneinander betreibbare Bereiche (14',14'',14''',14'''')unterteilt ist, und dass ferner eine Logikschaltung (33) vorgesehen ist, mittels welcher die Betriebsweise in ausgewählten Bereichen der Lichtemitterfolie wahlweise zwischen zwei Betriebsarten, wie z.B. Dauerbetrieb und Blinkbetrieb umschaltbar ist.

12. Tastatur nach Anspruch 11, wobei die Tasten mit einem Tastaturinterface (30) zur Auswertung der Tastenbetätigungen verbunden sind, dadurch gekennzeichnet, dass das Tastaturinterface mit der Logikschaltung (33) verbunden ist, derart, dass sich bei Tastenbetätigung der Betriebszustand der Lichtemitterfolie (14) mindestens im entsprechenden Bereich ändert.

13. Elektronische Schaltung mit Tastatur nach einem vorangehenden Ansprüche, dadurch gekennzeichnet, dass die Lichtemitterfolie in mehrere, unabhängig voneinander betreibbare Bereiche unterteilt ist, wobei in den einzelnen Bereichen die Betriebsweise der Lichtemitterfolie wahlweise zwischen mehreren Betriebsarten umschaltbar ist, und dass die Tastatur für die Befehls- und/oder Dateneingabe vorgesehen ist, wobei eine Anordnung für die Lichtquittierung einer Eingabe vorgesehen ist, derart, dass sich mit einer Eingabe die Betriebsart mindestens in einem der Teil Tastenfelder ändert.

_Fig.1_

_Fig.2_

Fig.3

Fig.4

EP 0 502 452 A1

Europäisches
Patentamt

# EUROPÄISCHER RECHERCHENBERICHT

Nummer der Anmeldung

EP    92 10 3524

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| Y | EP-A-0 143 734 (ESSEX GROUP INC.) <br> * Seite 6, Zeile 7 - Seite 9, Zeile 12; Abbildung 1 * <br> --- | 1-3,5,7 | H03K17/96 |
| Y | CH-A-675 028 (DYNALAB AG) <br> * Spalte 1, Zeile 63 - Spalte 3, Zeile 18; Abbildung 1 * <br> --- | 1-3,5,7 | |
| D,A | EP-A-0 210 386 (SCHENK & CO.) <br> * Spalte 6, Zeile 12 - Zeile 27; Abbildung 6 * <br> --- | 8 | |
| A | US-A-3 339 104 (KUSHNER ET AL.) <br> * Spalte 2, Zeile 49 - Spalte 3, Zeile 7; Abbildung 3A * <br> ----- | 9 | |
| | | | **RECHERCHIERTE SACHGEBIETE (Int. Cl.5 )** <br><br> H03K |

Der vorliegende Recherchenbericht wurde für alle Patentansprüche erstellt

| Recherchenort | Abschlußdatum der Recherche | Prüfer |
|---|---|---|
| DEN HAAG | 11 JUNI 1992 | CANTARELLI R.J.H. |